# EUROPEAN PATENT APPLICATION

(11) **EP 2 375 462 A1**
(43) Date of publication of application: **12.10.2011**
(21) Application number: 10159328.3
(22) Date of filing: 08.04.2010
(51) Int. Cl.: H01L 33/56

(54) **Light emitting diode package and method of fabricating the same**

(71) Applicant: Samsung LED Co., Ltd., Gyunggi-do (KR)
(72) Inventor: Park, Na-Na, 138-160 Seoul (KR); Kwak, Chang-Hoon, 139-052 Seoul (KR); Park, Il-Woo, 443-756 Gyeonggi-do (KR)
(74) Representative: Grünecker, Kinkeldey, Stockmair & Schwanhäusser Anwaltssozietät

(57) **Abstract**

The present invention relates to a light emitting diode package and a method of fabricating the same capable of uniformly distributing a fluorescent substance (151) in a molding member (150) by including a light emitting diode chip (130) on a package substrate (110) and the molding member having a molding resin (153), a fluorescent substance (151) and nano particles (152), which is arranged on the package substrate, with covering the light emitting diode chip.

## Description

### BACKGROUND OF THE INVENTION

### 1. Field of the Invention

The present invention relates to a light emitting diode package, to a light emitting diode package including a molding member containing nano particles for uniformly distributing fluorescent substance and a method of fabricating the same.

### 2. Description of the Related Art

A light emitting diode has various advantages of long life time, low consumption power, rapid response time and excellent initial driving characteristics or the like in comparison with a light emitting device based on a filament. In addition, the light emitting diode continuously enlarges its application fields to the center of the display usage due to its miniaturization.

Like this, a white light emitting diode device to implement a white color among light emitting diode devices is widely used as a high power and high efficiency light source capable of substituting for an illumination apparatus and a back light of a display device.

The white light emitting diode device utilizes the blue light emitting diode for implementing a blue color and a phosphor layer for converting the wavelength by being arranged on the blue light emitting diode. Herein, for forming the phosphor layer, after distributing the phosphor to the molding resin, the molding resin on which the phosphor is distributed is dropped on the light emitting diode chip by using a dispensing process. And then, by solidifying the molding resin dropped on the light emitting diode chip, the phosphor layer can be formed.

At this time, there is a problem that the phosphor on which the phosphor distributed on the molding resin during the solidifying process of the molding resin is deposited. In this result, since the phosphor can be non-uniformly arranged on the light emitting diode chip, the wavelength of the light generated to the light emitting diode chip cannot be uniformly converted, which in turn, the color temperature can be changed according to the deflection angle, thereby generating a color stain phenomenon. In order to improve this, although a lot of phosphor can be distributed in comparison with the molding resin, the brightness can be deteriorated due to the increment of the phosphor.

And also, by providing a reflection surface around the light emitting diode chip, the light emission efficiency can be improved, if the phosphor is arranged on the reflection surface by being deposited, the reflection efficiency of the reflection surface is deteriorated, which in turn, the light emission brightness can be deteriorated.

Particularly, the problem of the phosphor deposition is more critical when various phosphors are used by being mixed. That is, if the red color, the green color and the blue color phosphors are mixed on the ultraviolet light emitting diode to be used for realizing the white color light, the non-uniformity problem of colors becomes more severe as each phosphor has different concentration and particle size.

And also, since the degree of deposition becomes to be different according to the dispensing process and the solidifying time, the color coordinate distribution can be generated according to the products since the color coordinate can be changed according to the process time.

Accordingly, in order to form a conventional white light emitting diode device, although the phosphor utilizes the distributed molding resin, the light emission brightness and the color characteristics are deteriorated due to the deposition of phosphor in the molding resin, as well as the color coordinate distribution according to the products is generated.

### SUMMARY OF THE INVENTION

The present invention has been invented in order to overcome the above-described problems and it is, therefore, an object of the present invention to provide a light emitting diode package including a molding member containing nano particles to uniformly distribute fluorescent substance in the molding member and a method of fabricating the same.

In accordance with one aspect of the present invention to achieve the object, there is provided a light emitting diode package including: a light emitting diode chip on a package substrate; and a molding member including a molding resin, a fluorescent substance and nano particles, which is arranged on the package substrate, with covering the light emitting diode chip.

Herein, the nano particles is a mixture made of any one or more than two materials selected from a group consisting of aluminum oxide(Al₂O₃) based, silicon oxide(Si0₂), fumed silica and titanium oxide(TiO2).

And, the nano particles are included in content of 0.5% to 5% with reference to the content of the molding resin.

And also, the light emitting diode package further includes a package mold encompassing a peripheral of the molding member including the light emitting diode chip, wherein the package mold is arranged on the package substrate.

In accordance with another aspect of the present invention to achieve the object, there is provided a method of fabricating a light emitting diode package comprising the steps of: preparing a package substrate; mounting a light emitting diode chip on the package substrate; and forming a molding member including a fluorescent substance, a molding resin and nano particles, wherein the molding member is arranged on the package substrate with covering the light emitting diode chip.

Herein, the molding member is formed by dispensing method.

And, the method of fabricating the light emitting diode package further includes a step of removing air bubbles formed by composite for forming the molding member, after forming the composite for forming the molding member before the step of forming the molding member.

And also, the nano particles is a mixture made of any one or more than two materials selected from a group consisting of aluminum oxide(Al2O3) based, silicon oxide(SiO2), fumed silica and titanium oxide(TiO2).

And also, the nano particles are included in content of 0.5% to 5% with reference to the content of the molding resin.

And also, the method of fabricating the light emitting diode package further includes a step of: forming a package mold encompassing a peripheral of the light emitting diode chip on the package substrate between the step of mounting the light emitting diode chip and the step of forming the molding member.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a cross-sectional view illustrating a light emitting diode package in accordance with a first embodiment of the present invention;

FIGS. 2 to 4 are cross-sectional views illustrating a method of fabricating a light emitting diode package in accordance with a second embodiment of the present invention; and

FIG. 5 is a graph comparing brightness deterioration rates according to the time of light emitting diode package depending on the content of nano particles.

### DETAILED DESCRIPTION OF THE PREFERABLE EMBODIMENTS

Hereinafter, embodiments of the present invention for a light emitting diode package will be described in detail with reference to the accompanying drawings. The following embodiments are provided as examples to fully convey the spirit of the invention to those skilled in the art. Therefore, the present invention should not be construed as limited to the embodiments set forth herein and may be embodied in different forms. And, the size and the thickness of an apparatus may be overdrawn in the drawings for the convenience of explanation. The same components are represented by the same reference numerals hereinafter

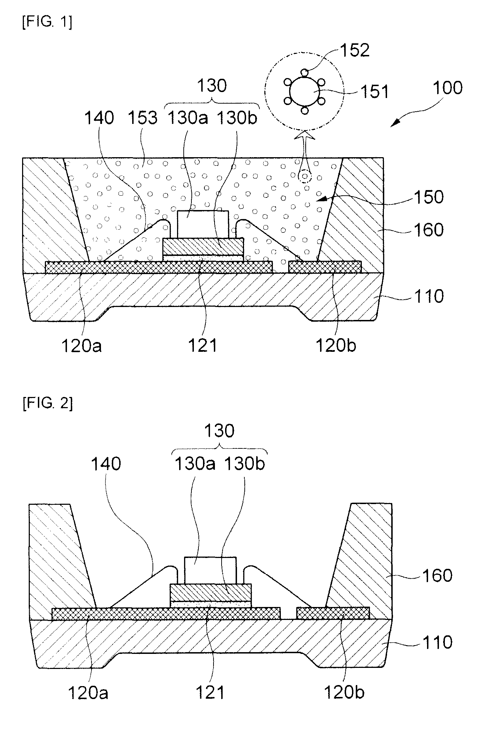

FIG. 1 is a cross-sectional view illustrating a light emitting diode package in accordance with a first embodiment of the present invention.

Referring to FIG. 1, in accordance with the embodiment of the present invention, the light emitting diode package 100 includes a package substrate 110, a light emitting diode chip 130 and a molding member 150.

The package substrate 110 includes a pair of lead frames 120a and 120b electrically connected with the light emitting diode chip 130. In addition, a package mold 160 may be further included on a top surface of the package substrate 110. The package mold 160 may include a cavity to expose portions of the lead frames 120a and 120b outside. Herein, the package substrate 110 and the package mold 160 are formed with the same material.

The light emitting diode chip 130 is mounted on the lead frames 120a and 120b in the cavity. Herein, the light emitting diode chip 130 is fixed to the package substrate 110 by using an adhesion member 121. Also, the light emitting diode chip 130 and the lead frames 120a and 120b may be electrically connected to each other by wires 140.

Herein, the light emitting diode chip 130 may be a flip chip including a chip substrate 130b and a light emitting diode device 130a mounted on the chip substrate 130b which is bond in a flip chip. However, the first embodiment of the present invention does not limit the type of the light emitting diode chip 130. And, the light emitting diode device 130a may a semiconductor device to be emitted by the current applied thereto. The light emitting diode device 130a may form the light having a single wavelength such as ultraviolet or blue color.

The molding member 150 is arranged on the package substrate 110, i.e., inside the cavity, with covering the light emitting diode chip 130. The molding member 150 includes a molding resin 153, a fluorescent substance 151 and nano particles 152.

The molding resin 153 can play a role of protecting the light emitting diode chip 130. The molding resin 153 may be formed of a transparent material such as a silicon based resin, an epoxy based resin and a mixed resin thereof or the like.

And also, the fluorescent substance 151 is excited by the light from the light emitting diode chip 130, the excited light emits the light having different wavelength. For example, a white light can be implemented by mixing the light from the fluorescent substance 151 with the blue light from the light emitting diode chip 130. At this time, the fluorescent substance 151 may be a yellow phosphor. But, the fluorescent substance 151 is not limited to this; it can be selectively mixed with at least two among the blue color, green color, yellow color and red color.

Herein, if the fluorescent substance 151 is non-uniformly distributed on the molding member 150, the brightness and color characteristics can be deteriorated as well as the problem of generating a color coordinate distribution according to products can be generated.

Therefore, as the molding member 150 includes the nano particles 152, the molding member 150 can includes the fluorescent substance 151 which is uniformly distributed. In addition, a portion of the nano particles 152 is adsorbed to the surface of the fluorescent substance 151, thereby preventing the fluorescent substance 151 from being deteriorated by heat or moisture. And also, the nano particles 152 can play a role of discharging the heat formed from the light emitting diode chip 130. Accordingly, the reliability of the light emitting diode package 100 can be improved.

Herein, for example, the material used for the nano particles 152 can be a mixture made of any one or more than two materials selected from a group consisting of aluminum oxide(Al2O3) based, silicon oxide(Si02), fumed silica and titanium oxide(TiO2).

And also, although the size of the nano particles 152 may be several nm to several hundred nm, it is preferable that the nano particles 152 have the size of 5 to 30 nm considering of the characteristics of lights.

And also, the nano particles 152 can be included into the molding member 150 with being ranged from 0.5% to 5% with reference to the content of the molding resin 153. Herein, if the content of the nano particles 152 is below 0.5%, there is no effect to improve the dispersibility of the fluorescent substance 151. Whereas, if the content of the nano particles 152 is above 5%, it deteriorates the brightness by impeding the light emission of the fluorescent substance 151.

Accordingly, the uniform color coordinate can be obtained according to the brightness of the light emitting diode package and products, as the nano particles are included in the embodiments of the present invention to distribute the fluorescent substance uniformly in the molding member.

And also, the nano particles can improve the reliability of the light emitting diode package by preventing the fluorescent substance from being deteriorated due to the heat and moisture.

FIGS. 2 to 4 are cross-sectional views illustrating a method of fabricating a light emitting diode package in accordance with a second embodiment of the present invention.

Referring to FIG. 2, a package substrate 110 is provided to manufacture a light emitting diode package 100.

The package substrate 110 includes a pair of lead frames 120a and 120b electrically connected to the light emitting diode chip 130. And also, a package mold 160 having a cavity on a top surface of the package substrate 110 can be further included.

Thereafter, the light emitting diode chip 130 is mounted on the lead frames 120a and 120b. Herein, the light emitting diode chip 130 is arranged in the cavity. That is, the package mold 160 encompasses a periphery of the light emitting diode chip.

The light emitting diode chip 130 can be fixed on the package substrate by an adhesive member 121. And also, the light emitting diode chip 130 can be electrically connected to the lead frames 120a and 120b by a wire bonding method. Herein, although the light emitting diode chip 130 can be a flip chip type including a chip substrate 130b and a light emitting diode device 130a mounted on the chip substrate 130b, the embodiment of the present invention does not limit to this.

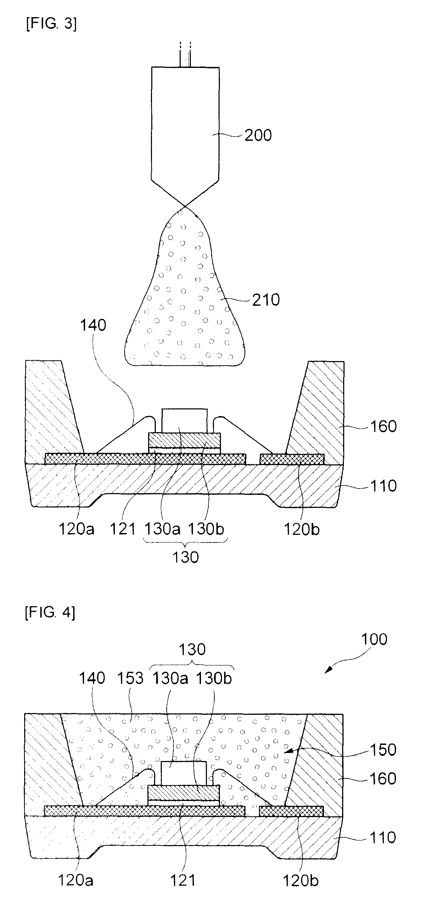

Referring to FIG. 3, the package substrate 110 including the light emitting diode chip 130 is supplied to a dispensing apparatus 200.

Meanwhile, a composite 210 for forming the molding member is formed.

The composite 210 for forming the molding member can be formed by mixing the fluorescent substance, the molding resin and the nano particles.

The molding resin can be made of a transparent material such as a silicon base resin, epoxy based resin and a mixed resin thereof or the like.

The fluorescent substance can be a material to play a role of converting the wavelength of light formed in the light emitting diode chip. For example, in case of obtaining a white light, if the light emitting diode chip emits blue color, the fluorescent substance can be yellow phosphor. But, the fluorescent substance does not limit to this, it can be obtained by mixing at least two among blue color, green color, yellow color and red color.

The nano particles play a role of distributing the fluorescent substance uniformly in the molding resin. The nano particles encompass the fluorescent substance, thereby preventing the fluorescent substance from being condensed to each other or deposited in the molding resin. And also, the nano particles play a role of controlling a thixotropic index of the composite to thereby maintain the viscosity of the composite uniformly. Therefore, the fluorescent substance can be uniformly distributed in the molding resin without deposition phenomenon.

And also, as the thixotropic index of the composite 210 for forming the molding member can be controlled, the molding member can be manufactured by a dispending method as well as various processes, for example a printing process.

And also, the nano particles can prevent the fluorescent substance from being deteriorated due to the heat or the moisture by being adsorbed on the surface of the fluorescent substance. Further, the nano particles play a role of discharging the heat generated from the light emitting diode chip 130 to outside. Accordingly, the reliability of the light emitting diode package can be improved.

For example, the nano particles can be a mixture made of any one or more than two materials selected from a group consisting of aluminum oxide(Al2O3) based, silicon oxide(SiO2), fumed silica and titanium oxide(TiO2).

Although the size of the nano particles may be several nm to several hundred nm, it is preferable that the nano particles have the size of 5 to 30 nm considering of the characteristics of lights.

The nano particles can be included in the molding member in content ranged from 0.5% to 5% with reference to the content of the molding resin considering that the dispersivity and brightness of the fluorescent substance are not deteriorated.

In the process of forming the composite 210 for forming the molding member, there occur a lot of bubbles due to the nano particles. The bubbles can generate the height deviation of the molding member during the dispensing process. In this result, a process of de-airing to remove the bubbles from the composite 210 for forming the molding member can be further performed since the color distribution of the light emitting diode package can be generated.

After the composite 210 for forming the molding member is supplied into the dispensing apparatus 200, the dispensing apparatus 200 drops the composite 210 for forming the molding member on the package substrate 110 including the light emitting diode chip 130. At this time, in the composite 210 for forming the molding member, the fluorescent substance is stably distributed by the nano particles. And also, in the dropped composite for forming the molding member, the fluorescent substance can be uniformly distributed.

And then, by solidifying the dropped composite for forming the molding member, the molding member 150 filled inside the cavity can be formed with covering the light emitting diode chip 130. Herein, in the solidifying process, the molding member 150 can obtain the uniformly distributed fluorescent substance by allowing the nano particles to distribute the fluorescent substance stably.

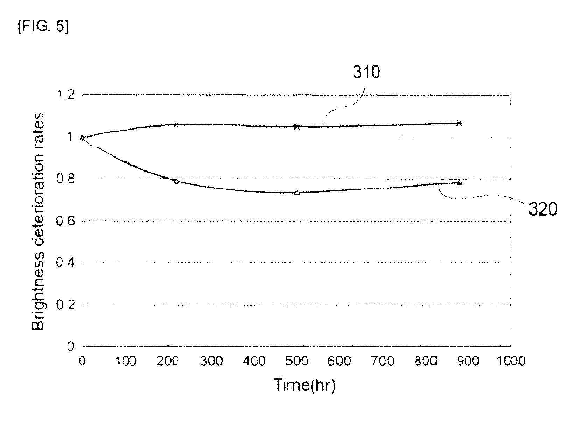

FIG. 5 is a graph comparing brightness deterioration rates according to the time of light emitting diode package depending on the content of nano particles. Herein, the first light emitting diode package includes a molding member provided with the nano particles and a second light emitting diode package includes a molding member not provided with the nano particles. An also, the brightness deterioration rate is obtained by measuring the brightness of the light emitting diode package driven by applying current of 20 mA under the conditions of temperature of 50 °C and humidity of 95%. Herein, the brightness deterioration rate is a value relatively converted in condition that an initial brightness value is referred to 1 and the measured value of the brightness according to the time is substituted for the reference value 1.

As shown in FIG. 5, the first light emitting diode package 310 including the nano particles does not have changes of the brightness deterioration rate nearly according to the time. This is because the nano particles prevent the fluorescent substance from being deteriorated due to the heat or moisture by being adsorbed to the surface of the fluorescent substance. And also, the heat generated in the light emitting diode chip can be effectively discharged through the nano particles. Accordingly, the reliability of the light emitting diode package can be improved. Whereas, the second light emitting diode package 320 not provided with the nano particles is deteriorated in the brightness according to the time. This is because the fluorescent substance is deteriorated due to the outside heat or moisture to thereby affect the wavelength conversion of the fluorescent substance.

Therefore, in the light emitting diode package in accordance with the embodiment of the present invention, by including the nano particles in the molding member, the deterioration of brightness characteristics according to the time is prevented, which in turn, the reliability of the light emitting diode package can be secured.

And also, by increasing the thixotropic index of the composite for forming the molding member due to the nano particles, the molding member can be fabricated by a dispensing method as well as a printing process or the like.

And also, since the nano particles can form the molding member having uniformly distributed fluorescent substance by improving the distribution property of the fluorescent substance, the light emitting diode package can improve the brightness and the color characteristics, which in turn, the color coordinate distribution according to products can be reduced.

The light emitting diode package of the present invention is capable of uniformly distributing the fluorescent substance in the molding member according to preventing the deposition and condensation of the fluorescent substance by providing the nano particles. Accordingly, the light emitting diode package can improve the light emission brightness and color characteristics and reduce the color coordinate distribution according to the products.

And also, the nano particles play a role of discharging the heat formed from the light emitting diode chip as well as play a role of preventing the fluorescent substance from being deteriorated from the moisture and oxygen to thereby improve the reliability of the light emitting diode package.

And also, the nano particles can improve the thixotropic index of the composite for forming the molding member, thereby the molding member can be formed by using a dispensing method as well as various manufacturing processes.

As described above, although the preferable embodiments of the present invention have been shown and described, it will be appreciated by those skilled in the art that substitutions, modifications and variations may be made in these embodiments without departing from the principles and spirit of the general inventive concept, the scope of which is defined in the appended claims and their equivalents.

## Claims

1. A light emitting diode package comprising:
a light emitting diode chip on a package substrate; and
a molding member including a molding resin, a fluorescent substance and nano particles, which is arranged on the package substrate, with covering the light emitting diode chip.

2. The light emitting diode package of claim 1, wherein the nano particles is a mixture made of any one or more than two materials selected from a group consisting of aluminum oxide(Al2O3) based, silicon oxide(SiO2), fumed silica and titanium oxide(TiO2).

3. The light emitting diode package of claim 1, wherein the nano particles are included in content of 0.5% to 5% with reference to the content of the molding resin.

4. The light emitting diode package of claim 1, further comprising a package mold encompassing a peripheral of the molding member including the light emitting diode chip, wherein the package mold is arranged on the package substrate.

5. A method of fabricating a light emitting diode package comprising the steps of:
preparing a package substrate;
mounting a light emitting diode chip on the package substrate; and
forming a molding member including a fluorescent substance, a molding resin and nano particles, wherein the molding member is arranged on the package substrate with covering the light emitting diode chip.

6. The method of claim 5, wherein the molding member is formed by dispensing method.

7. The method of claim 5, further comprising a step of removing air bubbles formed by composite for forming the molding member, after forming the composite for forming the molding member before the step of forming the molding member.

8. The method of claim 5, wherein the nano particles is a mixture made of any one or more than two materials selected from a group consisting of aluminum oxide(Al2O3) based, silicon oxide(SiO2), fumed silica and titanium oxide(TiO2).

9. The method of claim 5, wherein the nano particles are included in content of 0.5% to 5% with reference to the content of the molding resin.

10. The method of claim 5, further comprising a step of:
forming a package mold encompassing a peripheral of the light emitting diode chip on the package substrate between the step of mounting the light emitting diode chip and the step of forming the molding member.
